# EUROPEAN PATENT APPLICATION

(11) **EP 1 162 400 A2**
(43) Date of publication of application: **12.12.2001**
(21) Application number: 01109899.3
(22) Date of filing: 24.04.2001
(51) Int. Cl.: F21S 2/00, H01L 25/075

(54) **Modular lighting elements with leds (light-emitting diodes)**

(30) Priority: 09.06.2000 IT PD000162
(71) Applicant: Omnilux s.r.l., 35120 Padova (IT)
(72) Inventor: Callegari, Stefano, 35120 Padova (IT)
(74) Representative: Gustorf, Gerhard, Dipl.-Ing.

(57) **Abstract**

The invention concerns new modular lighting elements (M) comprising a printed circuit (B), at least one male connector (Cm) and at least one female connector (Cf), series of LEDs (light-emitting diodes) (L) connected in series in groups and integrated circuits (I) for the adjustment of the current supplied to the LEDs; the connectors (Cf,Cm) are electrically and directly connected to each other and said connection lines (La,Lb) for the connectors supplies power to one or more microchips that in turn supplies/supply power to a series of LEDs.

The printed circuit (B) may have any shape, for example it may be linear, rectangular, angular, T-shaped, arc-shaped, square, circular or polyhedral, regular or irregular. It is possible to carry out a modular lighting system comprising one or more lighting elements (M).

## Description

The present invention concerns the sector of lighting equipment and in particular it concerns lighting equipment with diffused light and low luminosity.

Many types of lighting equipment are known: with direct light, indirect light or diffused light.

The lighting equipment with diffused light usually comprises a lighting element - an incandescent or neon light bulb - and an opaline or refractor screen.

At present, to obtain more diffused lighting or to increase the development of the light source more independent lighting devices positioned one near the other are used, with the drawback that it is necessary to combine the shapes of the various lighting devices.

The present invention concerns in particular those situations in which lighting with high technological content is required, where the light source must be positioned with great precision in order to obtain the best results in terms of illumination engineering. Examples of the possible applications of this type of lighting equipment may range from the lighting of objects inside the display cases of exhibitions and museums, to containers in general, to the lamps to be positioned on writing desks or in indoor or outdoor spaces.

The subject of the present invention is a series of modular lighting elements, with reduced dimensions, suitable for creating lighting equipment with diffused light powered by a single line, which can be employed mainly in those situations where the dimensions of modern lighting equipment are unsuitable, at the same time ensuring optimal luminous efficiency.

The rigid structure of the assembly support (the printed circuit) is suitable for being fixed on a few points or even for being inserted in grooves made for this purpose in the plastic or aluminium extruded parts that are used for the production of most modern furnishing structures with frames, or for being inserted in any other duly processed material, thus making the assembly phase extremely quick.

Besides the above mentioned easy and quick assembly ensured by the stiffness of the support, the solution presented offers other economic and technical advantages:
- quick design, thanks to the use of CAE software systems;
- quick implementation, thanks to the numerical control machines used for the assembly of the components;
- modularity, which grants the possibility to find the shape suitable for the customer's needs even after sale;
- easy installation, thanks to the use of a few supports or of a bayonet system;
- economic solution , since the components used are available on the market;
- reliability and sturdiness;
- easy integration with other items already owned by the customer.

The new modular lighting elements comprise in their main parts a printed circuit, one or more series of LEDs, two or more connectors, one or more integrated monitoring circuits.

The printed circuit is constituted by an electrically insulating support on which tracks are provided for the direct electrical connection of the connectors and for the connection with the microchips for the LEDs, the support being also provided with assembly holes and having the double function of supporting all the other parts and of providing the electrical connection for all parts.

The printed circuit may have any shape, for example it may be linear, rectangular, angular, T-shaped or arc-shaped.

The connectors are electrical connectors of the male/female type, that is, for each modular lighting element two or more connectors are preferably provided, at least one male connector and one female connector.

These connectors are electrically connected to each other without any electrical element interposed in series, so that the electric power received by one of the connectors is directly supplied to the other.

The LEDs - light-emitting diodes - are applied to the printed circuit according to any possible arrangement, but they are preferably aligned. These LEDs are divided in groups and the LEDs of each group are connected in series.

The integrated circuits having the purpose of adjusting the electrical current supplied to the LED groups are interposed between the power supply line that connects the connectors and the LED groups.

In other words, the electrical connections for each module can be summarized as follows: direct connection between the connectors, parallel connection between the connector line and the integrated circuits, series connection between the LED groups that in turn are connected with the integrated circuits. Several modular lighting elements produced as described above can be connected in series through male and female connectors provided on them, thus arranging the modular lighting elements in such a way as to form a line or another shape, each modular lighting element being provided with a series of LEDs.

Power is supplied to this series of modular lighting elements by means of an appropriate transformer capable of supplying sufficient voltage and amperage to all the LEDs of all the modular lighting elements.

The modular lighting elements produced as described above offer a series of advantages: the light emitted by the LEDs is diffused; the light source is not a point, but it is distributed on a surface or a line; several modular lighting elements can be joined to one another without additional connections in a very simple and quick way and using a single source of electric current; by combining several modular elements it is possible to increase the quantity of light emitted and diffused, as well as the distribution of the light sources on a larger area.

In the system proposed every series of LEDs should be controlled by a microchip and this requires and guarantees the perfect knowledge of the current passing through each LED, thus ensuring uniformity, long life and maximum results in terms of illumination engineering, at the same time avoiding voltage variations in the measure allowed by the components employed. Furthermore, thanks to this control system, there is no need to provide power supplies whose size must be proportioned to the number of LEDs that will probably be employed, or, vice versa, to limit the number of LEDs according to the size of the power supply: since the microchip has full control of the LED power supply, the printed circuit ensures an ample margin for the characteristics of the power supply, and therefore it is possible to provide an oversize power supply in view of larger future applications.

The possibility to have an oversize power supply is the basis of the idea proposing a quick system for the electrical connection of the printed circuits, since it is always the microchip that provides for the LED power supply, independently of what happens before.

Therefore, it is immediately possible to increase or decrease the number of printed circuits with no need to operate on the power supply unit, with obvious advantages in terms of rapidity in the modification of the system configuration. The number of printed circuits that can be connected in cascade is unlimited, since it depends exclusively on the dimensions of the tracks and of the power supply, with no negative implication if the involved quantity is excessive.

The following is just an example among many of a practical embodiment of the invention in question, illustrated in the attached drawings, wherein:

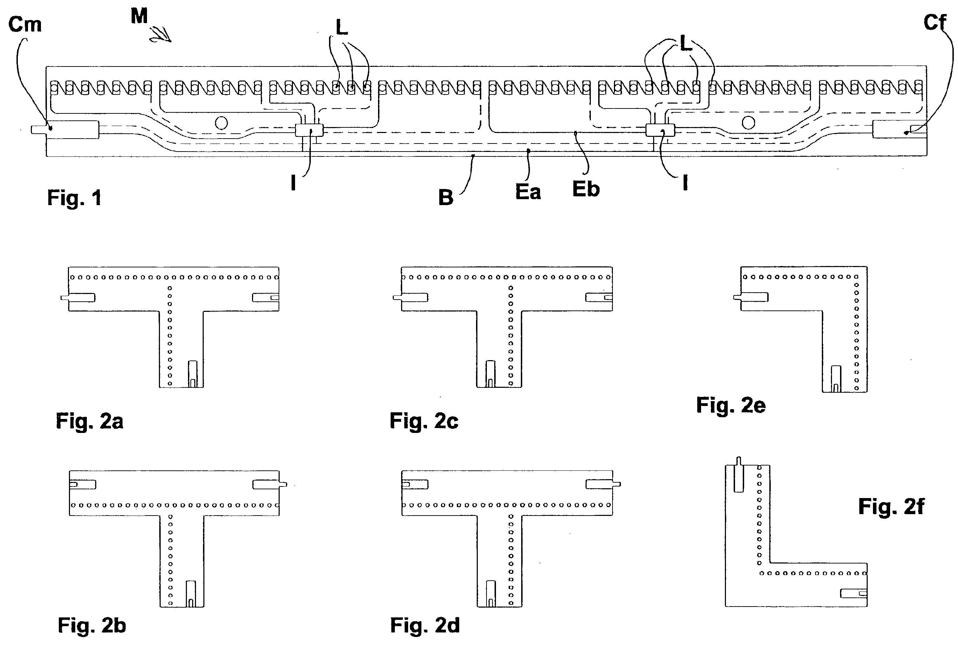

Figure 1 shows in detail a modular lighting element (M), comprising in its main parts a printed circuit (B), a male connector (Cm) and a female connector (Cf) connected to each other by means of conduction lines La and Lb, series of LEDs (L) connected in series in groups and integrated circuits (I) for the adjustment of the current supplied to the LEDs (L).

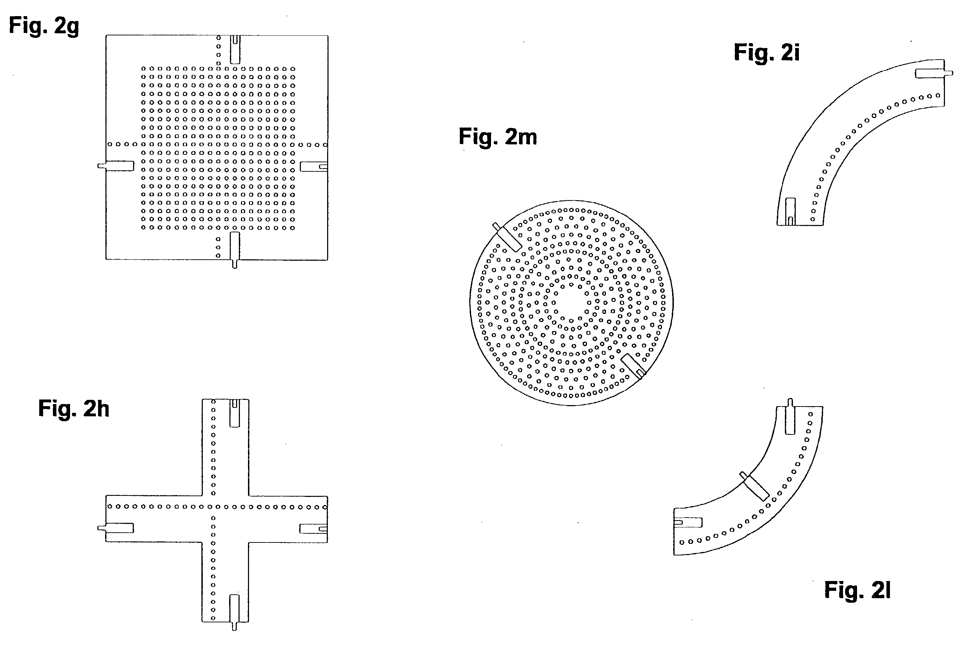

Figures 2a, 2b, 2c, 2d, 2e, 2f, 2g, 2h, 2i, 21, 2m, 2n show some possible embodiments of the modular lighting element, suitable for obtaining lighting devices having the desired shapes.

Therefore, with reference to the above specifications and the attached drawings, the following claims are put forth.

## Claims

1. Modular lighting elements, **characterized in that** they comprise a printed circuit, at least one male connector and at least one female connector, series of LEDs (light-emitting diodes) connected in series in groups and integrated circuits for the adjustment of the current supplied to the LEDs, and wherein the connectors are electrically and directly connected to each other, and wherein said connection line for the connectors supplies power to one or more microchips that in turn supplies/supply power to a series of LEDs.

2. Modular lighting elements according to claim 1, **characterized in that** the printed circuit may have any shape, for example it may be linear, rectangular, angular, T-shaped, arc-shaped, square, circular or polyhedral, regular or irregular.

3. Modular lighting system **characterized in that** it comprises one or more lighting elements produced according to claim 1 and 2.
